# EUROPEAN PATENT SPECIFICATION

(11) **EP 4 539 107 B1**
(45) Date of publication and mention of the grant of the patent: **09.12.2026**
(21) Application number: 25160366.8
(22) Date of filing: 22.05.2017
(51) Int. Cl.: H10P 95/00, H10W 20/00, H10W 20/44

(54) **SEAM-HEALING PROCESS IN DIFFUSION PROMOTING AMBIENT AT SUPRA-ATMOSPHERIC PRESSURE**
NAHTHEILUNGSVERFAHREN IN DIFFUSIONSFÖRDERNDER ATMOSPHÄRE UNTER SUPRAATMOSPHÄRISCHEM DRUCK
PROCÉDÉ DE CICATRISATION DE JOINTS EN MILIEU FAVORISANT LA DIFFUSION À PRESSION SUPRA-ATMOSPHÉRIQUE

(30) Priority: 10.06.2016 US 201662348547 P; 24.10.2016 US 201615332737
(43) Date of publication of application: 16.04.2025
(62) Document number(s) of the earlier application(s) in accordance with Art. 76 EPC: 17810695.1 / 3 469 626
(73) Proprietor: Applied Materials, Inc., Santa Clara, CA 95054 (US)
(72) Inventor: MEBARKI, Bencherki, Santa Clara, 95054 (US); KANG, Sean S., San Ramon, 94582 (US); WONG, Keith Tatseun, Mountain View, 94040 (US); REN, He, San Jose, 95130 (US); NAIK, Mehul B., San Jose, 95148 (US); YIEH, Ellie Y., San Jose, 95138 (US); NEMANI, Srinivas D., Sunnyvale, 94087 (US)
(74) Representative: Zimmermann & Partner Patentanwälte mbB

(56) References cited:
- WO-A1-2015/195081
- JP-A- 2001 060 621
- KR-B1- 101 005 740

## Description

### BACKGROUND

### Field

Embodiments of the present disclosure generally relate to integrated circuit fabrication methods, and in particular, to correcting seam defects in trenches or vias.

### Description of the Related Art

Many obstacles exist in the further miniaturization of semiconductor components. One such obstacle is the filling of metal interconnects, which affects the yield of modern CMOS devices. Metal interconnect signal lines make contact to lower conductive layers of the integrated circuit through vias that are formed in an insulating layer. It is desirable to fill the contact and interconnect with the metal that is used to form the interconnect layer so as to insure optimal operation of the device.

Conductive metals, such as copper, are presently the materials of choice for the fabrication of interconnect lines in integrated circuits. Conventional techniques used to fill interconnect lines generally include physical vapor deposition (PVD) or atomic layer deposition (ALD) of a barrier material, followed by a liner and then either copper reflow or electroplating.

When using conventional techniques, problems arise in the interconnect lines from the accumulation of relatively large grains of material at the upper surface of an insulating layer, as well as the accumulation of impurities within the conductive bulk. The accumulation of such grains at the edges of the contact via or interconnect can block or otherwise obstruct the contact or interconnect prior to completely filling the contact or interconnect, resulting in the formation of voids, seems, and uneven structures within the contact or interconnect. The aforementioned problem is particularly acute as integrated circuits are fabricated using smaller geometries.

The smaller contacts that are used in smaller geometry devices, such as contacts or interconnects in the tens of nanometers or less range, necessarily have a larger aspect ratio (i.e., relationship of feature height to width) than do larger geometry devices, thereby exacerbating the contact-filling or interconnect-filling difficulties described above. For example, unduly large voids can result in line resistance and contact resistance that are appreciably higher than designed. In addition, thinner regions of the conductive material adjacent to the contact or interconnect fill region will be subject to electro migration, which can result in the eventual opening of the circuits and failure of the device.
WO 2015/195081 A1 describes removing seams and voids in metal interconnects and associated techniques and configurations. An interconnect structure formed by depositing a metal may be further coupled with other similarly configured interconnect structures. The metal may be a non-copper metal having a melting point that is greater than a melting point of copper (e.g., greater than 1085°C). For example, the metal may be composed of ruthenium (Ru), molybdenum (Mo), tungsten (W) and/or cobalt (Co), equivalents, or combinations thereof. In some embodiments, the metal 304 may be composed of rhenium (Re), iron (Fe), osmium (Os), rhodium (Rh), iridium (Ir), nickel (Ni), palladium (Pd), platinum (Pt), titanium (Ti), zirconium (Zr), hafnium (Hf), vanadium (V), niobium (Nb), tantalum (Ta), chromium (Cr) and/or technetium (Tc), equivalents, or combinations thereof. The metal may be exposed to a temperature ranging from 300°C to 800°C for a time period ranging from 5 minutes to a couple of hours, under atmospheric pressure (~1 atm), in the presence of forming gas comprising hydrogen. Further, for example, the pressure may range from 1 atm to 10 atm or the hydrogen concentration may be greater than 5% by volume in some embodiments.
KR 101 005 740 B1 describes a copper wiring formation method of a semiconductor device. The method includes a substrate having a damascene pattern formed on an interlayer insulating film; forming a copper layer such that the damascene pattern is embedded; polishing the copper layer until the surface of the interlayer insulating film is exposed by a chemical mechanical polishing process to form a copper wiring in the damascene pattern; performing an annealing process in a deuterium atmosphere on the resultant product in which the copper wiring is formed; and forming a capping layer on the interlayer insulating film including the copper wiring. the annealing in the deuterium atmosphere can be performed in a furnace in a deuterium atmosphere of 10 to 3000 sccm at a temperature of 300 to 400°C and a pressure of 0.01 to 500 Torr for 1 to 60 minutes.

To address the above issues, other materials and deposition techniques have been considered. When using other fill techniques such as chemical vapor deposition (CVD), cyclical deposition/treat processes are employed. One approach utilizes multiple cycles of deposition and anneal in attempt to repair seams and cavities in the conductive material in low-to-sub atmospheric pressures process regimes. This approach results in extremely slow process time, and attempts to reduce process time have resulted in unsatisfactory resistivity. In other approaches, the deposited metal is subjected to extremely high pressures, such as 700 bar to 2000 bar, or more, in attempt to repair defects in the conductive material. The exerted pressure forces the deposited metal into the undesired voids within the deposited film. However, subsequent thermal post treatment to correct grain boundary defects or other defects results in partial or full reformation of the void. In addition, the pressures utilized in conventional approaches may result in physical damage to low-k dielectric materials adjacent the interconnect.

Therefore, this is a need for an improved method of correcting seam defects.

### SUMMARY

The invention is set out in the independent claims.

### BRIEF DESCRIPTION OF THE DRAWINGS

So that the manner in which the above recited features of the present disclosure can be understood in detail, a more particular description of the disclosure, briefly summarized above, may be had by reference to embodiments, some of which are illustrated in the appended drawings. It is to be noted, however, that the appended drawings illustrate only exemplary embodiments and are therefore not to be considered limiting of its scope.
Figure 1 is a flow diagram of a method for processing a substrate, according to one embodiment of the disclosure.
Figure 2A is a schematic sectional view a substrate having interconnects that include one or more defects from a gap-fill process.
Figure 2B is a schematic sectional view of the substrate of Figure 2A after processing according to embodiments described herein.

To facilitate understanding, identical reference numerals have been used, where possible, to designate identical elements that are common to the figures.

### DETAILED DESCRIPTION

Aspects of the disclosure include methods of treating a substrate to remove one or more of voids, seams, or grain boundaries from an interconnect formed on the substrate. The method includes heating the substrate in an environment pressurized at a pressure of about 1 bar to about 50 bar.

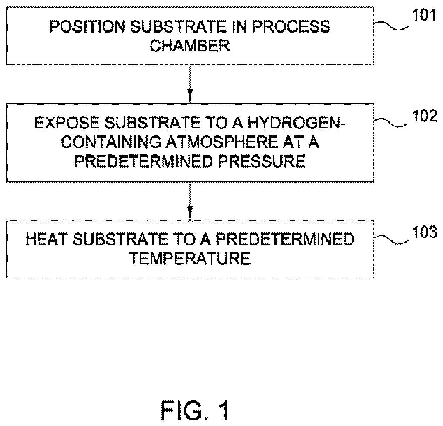

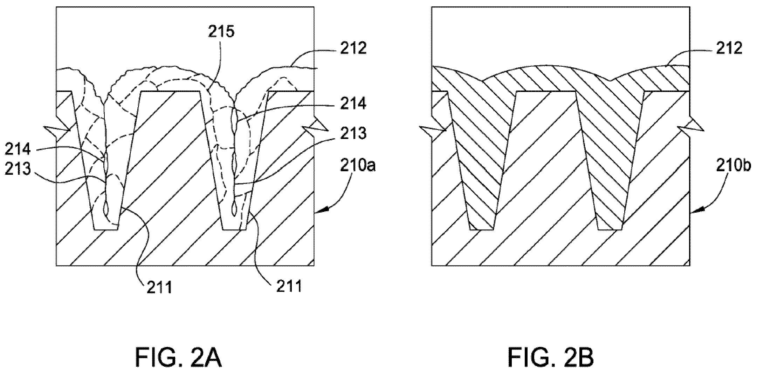

Figure 1 is a flow diagram of a method 100 for processing a substrate, according to one embodiment of the disclosure. Figure 2A is a schematic sectional view a substrate having interconnects that include one or more defects from a gap-fill process. Figure 2B is a schematic sectional view of the substrate of Figure 2A after processing according to embodiments described herein. To facilitate explanation of aspects of the disclosure, Figures 2A and 2B will be explained in conjunction with Figure 1.

Method 100 begins at operation 101. In operation 101, a substrate 210 is positioned in a process chamber. The substrate 210 includes one or more trenches 211 (two are shown) having a conductive material 212 deposited therein to form interconnects. The conductive material 212 is a metal, such as cobalt, copper, ruthenium, or aluminum, which may be deposited by CVD, PVD, ALD, plating, or other deposition methods. During deposition of the conductive material 212, one or more of a seam 213, a void 214, or grain boundaries 215 may form. The seams 213, the voids 214, and the grain boundaries 215 negatively affect performance of the interconnects by increasing electrical resistance of the interconnects.

In operation 102, the substrate 210 is exposed to a hydrogen-containing atmosphere at a predetermined pressure. The hydrogen-containing environment includes hydrogen gas and one or more non-reactive gases, such as diatomic nitrogen or argon. Hydrogen is present within a range of about 1 atomic percent to about 100 atomic percent, such as about 1 atomic percent to about 10 atomic percent, for example, about 2 atomic percent to about 5 atomic percent or about 3.5 atomic percent to about 4.5 atomic percent. In one example, hydrogen is present at about 4 atomic percent. It is contemplated that a lower atomic percentage of hydrogen may dictate longer processing times or elevated temperatures, while higher atomic percentages of hydrogen may dictate the use of additional hardware, such as interlocks. According to the embodiments, deuterium is used in place of, or in combination with, hydrogen in the atomic percentages described above.

The presence of hydrogen in the atmosphere of the process chamber weakens the surface bounds of the conductive material 212 to facilitate flow of the conductive material 212 into the voids 214. A supra-atmospheric pressure (e.g., a pressure greater than atmospheric pressure) is maintained in the process chamber while exposing the substrate 210 to the hydrogen-containing environment. In one example, the pressure within the process chamber is maintained within a range of about 1 bar to about 50 bar, such as about 1 bar to about 20 bar, for example about 5 bar to about 15 bar. In another example, the pressure within the process chamber is maintained within a range of about 12 bar to about 50 bar, such as about 12 bar to about 20 bar, for example about 12 bar to about 15 bar. The application of increased pressure in the presence of the hydrogen-containing environment facilitates movement of the conductive material 212 into the voids 214. In addition, the application of increased pressure may facilitate introduction of hydrogen into seam 213, the void 214, or even along the grain boundary 215, to remove contaminants trapped therein. Contaminants may be present as a result of the deposition process of the conductive material 212, or from sources within the process chamber. The presence of the contaminants within the conductive material 212 may further increase electrical resistance.

In operation 103, the substrate 210 is heated to a predetermined temperature. In one example, the predetermined temperature is about 250 degrees Celsius to about 400 degrees Celsius, such as about 300 degrees Celsius to about 400 degrees Celsius, for example, 400 degrees Celsius. It is contemplated that temperatures above about 400 degrees Celsius may adversely the structure of the substrate 210 adjacent to the conductive material 212. For example, excess temperatures may physically disrupt material adjacent the conductive material 212, resulting in leakage of electrical current. In one example, the temperature of the substrate remains below the melting point of the conductive material 212. Even though the melting point of the conductive material 212 may not be reached in aspects described herein, the elevated temperature in the presence of the elevated pressure and the hydrogen gas still facilitates atomic movement of the conductive material 212. Thus, filling of the voids 214 is promoted.

The increased temperature, in combination with the increased pressure and the hydrogen-containing environment, facilitate movement of the conductive material 212 into voids 214, while simultaneously healing or repairing any seams 213, reducing grain boundaries 215, and increasing grain size. The removal of seams 213, voids 214, and grain boundaries 215 occurs in a single operation after complete deposition of the conductive material 212.

In contrast, one known approach uses cyclical treatment/deposition processes, in which a small amount of material is deposited in a trench, such as about 20 angstroms to about 100 angstroms, and then the material is treated. This previously-attempted approach is very inefficient and time consuming due to the number of processes required. In addition, the treatment process of such an approach is a multiple step process, further increasing the number of operations which are performed.

In the multi-cycle treatment process, the substrate is first exposed to high temperatures to weaken the conductive material and merge grains through multi-iteration deposition and treatment cycles, which is very time consuming. Alternatively, the conductive material is subjected to high temperatures after subjecting the conductive material to high pressures (to close a void), which allows the voids to reopen or reform. The very high pressures utilized in previous approaches result in damage to the substrate adjacent the conductive material, due to the excessive force applied to the conductive material and transferred to the substrate.

However, the inventors of the present disclosure have discovered that pressures within a range of about 1 bar to about 50 bar or about 12 bar to about 50 bar, such as ab out 12 bar to 20 bar, in combination with simultaneous elevated temperatures and hydrogen gas, provides significant improvements over existing approaches. Specifically, seams and voids are repaired, and grain boundaries are reduced, in a single operation which does not subject the substrate 210 to undesirably elevated pressures. Notably, the pressure within a void 214 is about 1x10⁻⁸ bar when formed by a PVD process, and the inventors have determined that a pressure within a range of about 1 bar to about 50 bar, such as about 12 bar to about 50 bar, for example about 12 bar to about 20 bar, is sufficient to facilitate repair of seams 213 and voids 214. Thus, the extremely high pressures of conventional approaches, and the undesired consequences thereof, are avoided by aspects of the disclosure. Additionally, unlike existing approaches, the aspects described herein can repair seam, void, and grain defects after completely depositing the conductive material 212. Thus, aspects described herein are not subject to cyclical deposition-treatment, resulting in reduced process time per substrate.

Figure 2B schematically illustrates the substrate 210 after operation 103. As illustrated, method 100 has removed the grain boundaries 215, resulting in a single grain structure. Additionally, method 100 has also removed the seams 213 and the voids 214. The resulting conductive material 212 has a lower resistance than the conductive material illustrated in Figure 2A.

Figure 1 illustrates one embodiment of treating a substrate. In another aspect, operations 102 and 103 may occur simultaneously or in reverse order. In another example, the hydrogen gas may be excluded from operation 102. In such an example, the argon may facilitate reflow of the conductive material 212. However, due to the relatively larger size and reduced reactivity of argon compared hydrogen, argon may be less efficient than hydrogen at removing contaminants and weakening surface bonds of the conductive material 212.

Benefits of the aspects of the disclosure include reduced processing time since seams, voids, and grain boundaries can be corrected in a single operation, rather than in multiple cycles as occurs in existing processes. Additionally, aspects described herein can be performed using less expensive hardware as compared to hardware configured for significantly higher pressures, since significantly lower pressures are utilized in aspects of the disclosure. Additionally, the enhanced flow conditions of conductive metals when processed as described herein may facilitate the use of thinner liners, thus reducing materials expenses and allowing smaller geometries. In some instances, it is contemplated that the liner may be completely excluded. Aspects of the disclosure should not be limited to examples described herein, and may be applied to any instance of metal fill, such as 3D-NAND gate fill, CMOS logic gate fill, bit lines for memory devices, and the like.

While the foregoing is directed to embodiments of the present disclosure, other and further embodiments of the disclosure may be devised without departing from the basic scope thereof, and the scope thereof is determined by the claims that follow.

## Claims

1. A method of processing a substrate comprising:
depositing a conductive material on the substrate to form an interconnect having one or more seams or voids are formed therein;
heating the substrate to a predetermined temperature of about 250 degrees Celsius to about 400 degrees Celsius, wherein the predetermined temperature is below a melting point of the conductive material; and
healing the one or more seams or voids by exposing the interconnect to a hydrogen-containing atmosphere at a pressure between about 1 bar and about 50 bar, wherein the hydrogen-containing atmosphere comprises deuterium.

2. The method of claim 1, wherein the hydrogen-containing atmosphere includes hydrogen present within a range of about 1 atomic percent to about 100 atomic percent.

3. A method of processing a substrate comprising:
depositing a conductive material on the substrate to form an interconnect having one or more seams or voids are formed therein; and
healing the one or more seams or voids, wherein healing the one or more seams or voids comprises:
exposing the interconnect to a deuterium atmosphere at a pressure between about 1 bar and about 50 bar, wherein
the deuterium atmosphere has deuterium in a range between about 2 atomic percent to about 5 atomic percent; and
heating the substrate to a predetermined temperature of about 250 degrees Celsius to about 400 degrees Celsius, wherein the predetermined temperature is below a melting point of the conductive material.

4. The method of claim 3, wherein the exposing further comprises hydrogen, and wherein the exposing causes weakening of surface bonds of the conductive material.

5. The method according to claim 1, comprising:
positioning the substrate in a processing chamber, the substrate having the interconnect formed thereon; wherein the healing the one or more seams or voids simultaneously comprises:
the exposing the interconnect to a hydrogen-containing environment comprising the hydrogen-containing atmosphere at the supra-atmospheric pressure; and
the heating the substrate to the predetermined temperature.

6. The method of claim 5, wherein the supra-atmospheric pressure is between about 12 bar and about 50 bar.

7. The method of claim 5, wherein the hydrogen-containing environment includes hydrogen present within a range of about 1 atomic percent to about 100 atomic percent.

8. The method of any of claims 1 or 5, wherein the exposing weakens surface bonds of the conductive material.

9. The method of any of claims 1, 3 or 5, wherein healing the one or more seams or voids further comprises reducing the grain boundaries.

10. The method of claim 5, wherein the healing the one or more seams or voids facilitates movement of the conductive material.

11. The method of claim 5, wherein the healing the one or more seams or voids removes contaminates from the seams or voids.

## Patentansprüche

1. Verfahren zum Bearbeiten eines Substrats, umfassend:
Abscheiden eines leitfähigen Materials auf dem Substrat, um einen Interconnect zu bilden, die eine oder mehrere Nähte oder Hohlräume aufweist, die darin ausgebildet sind;
Erwärmen des Substrats auf eine vorbestimmte Temperatur von etwa 250 Grad Celsius bis etwa 400 Grad Celsius, wobei die vorbestimmte Temperatur unter einem Schmelzpunkt des leitfähigen Materials liegt; und
Ausheilen der einen oder mehreren Nähte oder Hohlräume durch Aussetzen des Interconnect gegenüber einer wasserstoffhaltigen Atmosphäre bei einem Druck zwischen etwa 1 bar und etwa 50 bar, wobei die wasserstoffhaltige Atmosphäre Deuterium umfasst.

2. Verfahren nach Anspruch 1, wobei die wasserstoffhaltige Atmosphäre Wasserstoff beinhaltet, der in einem Bereich von etwa 1 Atomprozent bis etwa 100 Atomprozent vorliegt.

3. Verfahren zum Bearbeiten eines Substrats, umfassend:
Abscheiden eines leitfähigen Materials auf dem Substrat, um einen Interconnect zu bilden, die eine oder mehrere Nähte oder Hohlräume aufweist, die darin ausgebildet sind; und
Ausheilen der einen oder mehreren Nähte oder Hohlräume, wobei das Ausheilen der einen oder mehreren Nähte oder Hohlräume umfasst:
Aussetzen des Interconnect gegenüber einer Deuteriumatmosphäre bei einem Druck zwischen etwa 1 bar und etwa 50 bar, wobei
die Deuteriumatmosphäre Deuterium in einem Bereich zwischen etwa 2 Atomprozent bis etwa 5 Atomprozent aufweist; und
Erwärmen des Substrats auf eine vorbestimmte Temperatur von etwa 250 Grad Celsius bis etwa 400 Grad Celsius, wobei die vorbestimmte Temperatur unter einem Schmelzpunkt des leitfähigen Materials liegt.

4. Verfahren nach Anspruch 3, wobei das Aussetzen ferner Wasserstoff umfasst, und wobei das Aussetzen ein Schwächen von Oberflächenbindungen des leitfähigen Materials bewirkt.

5. Verfahren nach Anspruch 1, umfassend:
Positionieren des Substrats in einer Bearbeitungskammer, wobei das Substrat den darauf ausgebildeten Interconnect aufweist; wobei das Ausheilen der einen oder mehreren Nähte oder Hohlräume gleichzeitig umfasst:
das Aussetzen des Interconnect gegenüber einer wasserstoffhaltigen Umgebung, welche die wasserstoffhaltige Atmosphäre bei dem überatmosphärischen Druck umfasst; und
das Erwärmen des Substrats auf die vorbestimmte Temperatur.

6. Verfahren nach Anspruch 5, wobei der überatmosphärische Druck zwischen etwa 12 bar und etwa 50 bar liegt.

7. Verfahren nach Anspruch 5, wobei die wasserstoffhaltige Umgebung Wasserstoff beinhaltet, der in einem Bereich von etwa 1 Atomprozent bis etwa 100 Atomprozent vorliegt.

8. Verfahren nach einem der Ansprüche 1 oder 5, wobei das Aussetzen Oberflächenbindungen des leitfähigen Materials schwächt.

9. Verfahren nach einem der Ansprüche 1, 3 oder 5, wobei das Ausheilen der einen oder mehreren Nähte oder Hohlräume ferner das Reduzieren der Korngrenzen umfasst.

10. Verfahren nach Anspruch 5, wobei das Ausheilen der einen oder mehreren Nähte oder Hohlräume eine Bewegung des leitfähigen Materials erleichtert.

11. Verfahren nach Anspruch 5, wobei das Ausheilen der einen oder mehreren Nähte oder Hohlräume Verunreinigungen aus den Nähten oder Hohlräumen entfernt.

## Revendications

1. Procédé de traitement d'un substrat comprenant :
• le dépôt d'un matériau conducteur sur le substrat pour former une interconnexion présentant un ou plusieurs joints ou vides formés dans celle-ci ;
• le chauffage du substrat à une température prédéterminée d'environ 250 degrés Celsius à environ 400 degrés Celsius, dans lequel la température prédéterminée est inférieure à un point de fusion du matériau conducteur ; et
• la cicatrisation des un ou plusieurs joints ou vides par l'exposition de l'interconnexion à une atmosphère contenant de l'hydrogène à une pression comprise entre environ 1 bar et environ 50 bars, dans lequel l'atmosphère contenant de l'hydrogène comprend du deutérium.

2. Procédé selon la revendication 1, dans lequel l'atmosphère contenant de l'hydrogène comprend de l'hydrogène présent dans une plage d'environ 1 pour cent atomique à environ 100 pour cent atomique.

3. Procédé de traitement d'un substrat comprenant :
• le dépôt d'un matériau conducteur sur le substrat pour former une interconnexion présentant un ou plusieurs joints ou vides formés dans celle-ci ; et
• la cicatrisation des un ou plusieurs joints ou vides, dans lequel la cicatrisation des un ou plusieurs joints ou vides comprend :
• l'exposition de l'interconnexion à une atmosphère de deutérium à une pression comprise entre environ 1 bar et environ 50 bars, dans lequel l'atmosphère de deutérium comporte du deutérium dans une plage comprise entre environ 2 pour cent atomique et environ 5 pour cent atomique ; et
• le chauffage du substrat à une température prédéterminée d'environ 250 degrés Celsius à environ 400 degrés Celsius, dans lequel la température prédéterminée est inférieure à un point de fusion du matériau conducteur.

4. Procédé selon la revendication 3, dans lequel l'exposition comprend en outre de l'hydrogène, et dans lequel l'exposition provoque un affaiblissement de liaisons de surface du matériau conducteur.

5. Procédé selon la revendication 1, comprenant :
• le positionnement du substrat dans une chambre de traitement, le substrat ayant l'interconnexion formée sur celui-ci ; dans lequel la cicatrisation des un ou plusieurs joints ou vides comprend simultanément :
• l'exposition de l'interconnexion à un environnement contenant de l'hydrogène comprenant l'atmosphère contenant de l'hydrogène à la pression supra-atmosphérique ; et
• le chauffage du substrat à la température prédéterminée.

6. Procédé selon la revendication 5, dans lequel la pression supra-atmosphérique est comprise entre environ 12 bars et environ 50 bars.

7. Procédé selon la revendication 5, dans lequel l'environnement contenant de l'hydrogène comprend de l'hydrogène présent dans une plage d'environ 1 pour cent atomique à environ 100 pour cent atomique.

8. Procédé selon l'une quelconque des revendications 1 ou 5, dans lequel l'exposition affaiblit des liaisons de surface du matériau conducteur.

9. Procédé selon l'une quelconque des revendications 1, 3 ou 5, dans lequel la cicatrisation des un ou plusieurs joints ou vides comprend en outre la réduction des joints de grains.

10. Procédé selon la revendication 5, dans lequel la cicatrisation des un ou plusieurs joints ou vides facilite le mouvement du matériau conducteur.

11. Procédé selon la revendication 5, dans lequel la cicatrisation des un ou plusieurs joints ou vides élimine les contaminants des joints ou vides.
